# EUROPEAN PATENT SPECIFICATION

(11) **EP 0 260 052 B1**
(45) Date of publication and mention of the grant of the patent: **14.04.1993**
(21) Application number: 87307730.9
(22) Date of filing: 02.09.1987
(51) Int. Cl.: H01L 31/02, H01L 31/10, H01L 21/203

(54) **Semiconductor device including ordered layers**
Geordnete Schichten enthaltende Halbleitervorrichtung
Dispositif à semi-conducteur comportant des couches bien ordonnées

(30) Priority: 11.09.1986 US 906488
(43) Date of publication of application: 16.03.1988
(73) Proprietor: AT&T Corp., New York, NY 10013-2412 (US)
(72) Inventor: Bevk, Joze, Berkeley Heights New Jersey 07922 (US); Feldman, Leonard Cecil, Berkeley Heights New Jersey 07922 (US); Glass, Alastair Malcolm, Rumson New Jersey 07760 (US); Pearsall, Thomas Perine, Summit New Jersey 07901 (US)
(74) Representative: Watts, Christopher Malcolm Kelway, Dr.

(56) References cited:
- APPLIED PHYSICS LETTERS, vol. 48, no. 1, 6th January 1986, pages 56-58, American Institute of Physics, Woodbury, New York, US; R. HULL et al.: "Stability of semiconductor strained-layer superlattices"
- IEEE ELECTRON DEVICE LETTERS, vol. EDL-7, no. 5, May 1986, pages 330-332, IEEE, New York, US; T.P. PEARSALL et al.: "Avalanche gain in GexSi1-x/Si infrared waveguide detectors"
- APPLIED PHYSICS LETTERS, vol. 49, no. 5, 4th August 1986, pages 286-288, American Institute of Physics, Woodbury, N.Y. US; J. BEVK et al.: "Ge-SI layered structures: Artificial crystals and complex cell ordered superlattices"
- APPLIED PHYSICS LETTERS, vol. 50, no. 12, 23rd March 1987, pages 760-762, American Institute of Physics, New York, US; J. BEVK et al.: "Structure and optical properties of Ge-Si ordered superlattices"

## Description

### Technical Field

The invention is concerned with semiconductor devices such as, e.g., optoelectronic devices.

### Background of the Invention

While, in an early period of semiconductor device development, single-element Group-IV materials such as germanium and silicon received primary consideration as device materials, subsequent discoveries have led to the investigation and use of other materials such as, e.g., Group III-V and Group II-VI compounds and, more recently, of hybrid systems including different semiconductor materials, e.g., in the form of alternating layers deposited on a substrate. These latter developments are likely to have a major impact especially in the field of optoelectronics, including the conversion of optical signals into electrical signals and vice-versa, where rapid expansion is taking place into major commercial areas.

Prominent in this respect is the area of telecommunications, where the use of optical fiber waveguide transmission media is combination with electronic switching systems has resulted in accelerated development of optoelectronic interface technology. At present, optoelectronic interfaces play a role primarily in long-distance communications which represent a primary field of use of optical fiber waveguides. This field is experiencing continued growth; furthermore, it is expected that optical fiber waveguides will be installed not only to augment existing long-distance capacity but also, in many instances, to replace existing facilities. And since the use of such waveguides is further expected to expand into the field of local area networks, rapidly increasing demand for optoelectronic devices appears assured.

Currently used optical fiber waveguides include a silica-based core-cladding structure which is highly transparent to infrared radiation having a wavelength near 1.6 micrometer where, more specifically, loss as well as dispersion are near their minimum values. As a result, there is strong interest in devices such as light sources and detectors (light-emitting diodes, lasers, photodiodes) which are active at the preferred wavelength. Invariably, demand is for solid-state devices.

While, in purely electronic device technology, silicon remains predominant as device material, the optical properties of silicon are such as to limit its usefulness in optoelectronics. For one thing, the bandgap of silicon is so large that optical activity at wavelengths greater than approximately 1 micrometer is precluded; for another, the transition across the bandgap is indirect, precluding light emission. Germanium, too, is poorly suited as an optoelectronic material: While germanium is capable of absorbing 1.6-micrometer radiation, its suitability as a photodetector material is limited because of its large noise factor.

Progress towards combining the sensitivity of germanium with the low-noise properties of silicon has been reported by T.P. Pearsall et al., "Avalanche Gain in Ge_{*x*}Si_{1-*x*}/Si Infrared Waveguide Detectors". *IEE Electron Device Letters,* Vol. EDL-7 (1986), pp. 330-332, where avalanche gain measurements are presented as obtained, e.g., with a strained-layer superlattice consisting of alternating layers of Si and of random Ge-Si having average composition Ge_{0.6}Si_{0.4}. Further progress with respect to objectives such as high sensitivity and low noise is desired, e.g. in the interest of providing low-cost alternatives to Group-III-V semiconductor optoelectronic devices.

*Applied Physics Letters,* vol. 49, No. 5, August 1986, pages 286-288, describes a Ge-Si layered structure with a sublayer thickness of two molecular layers grown on a (001) Si substrate.

### Summary of the Invention

In accordance with the invention, there is provided a semiconductor device as set out in claim 1. A structure of alternating first layers of 4 atomic monolayers Ge and second layers of 4 atomic monolayers Si is of particular interest for photodetector use on account of strong optical absorption at energies near 0.76 eV, corresponding to wavelengths near 1.6 micrometer.

### Brief Description of the Drawing

FIG. 1 schematically shows a photodiode representing an embodiment of the invention;
FIG. 2 schematically shows a photodiode in accordance with an alternate embodiment of the invention;
FIG. 3 is a schematic representation of a preferred layered structure as may be included in a device in accordance with the invention;
FIG. 4 is a schematic representation of an alternate layered structure as may be included in a device in accordance with the invention; and
FIG. 5 is a graphic representation of a functional relationship as determined based on measurement of electroreflectance of a preferred layered structure, measurement being as a function of the energy of incident electromagnetic radiation.

### Detailed Description

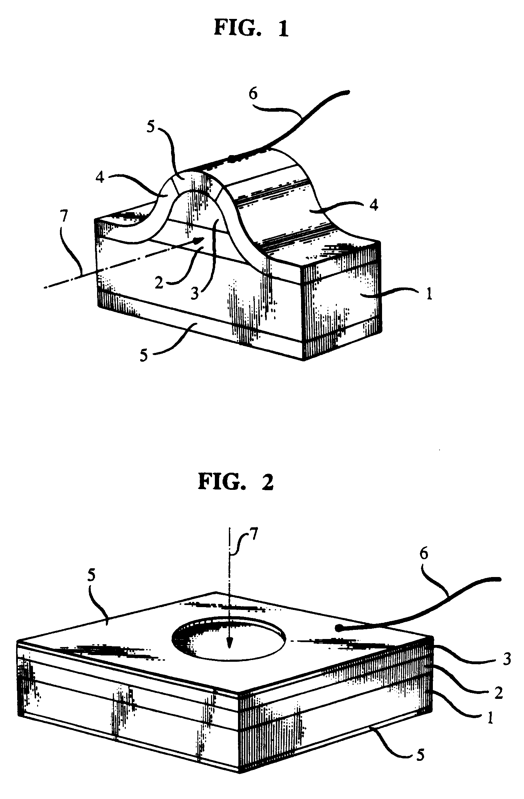

The photodiode represented in FIG. 1 comprises a silicon substrate 1 which is doped p⁺ and which typically includes a buffer layer. The photodiode further comprises an absorption region 2, a silicon cladding layer 3 which is doped n⁺, a silicon dioxide passivation layer 4, aluminum metallizations 5, and an electrical contact wire 6. Shown also is optical radiation 7 incident on absorption region 2 in a direction which is parallel to the deposited layers; such radiation may be, e.g., as emanating from an optical fiber waveguide or as focused, selected, or deflected by a lens, a mirror, a prism, or a grating.

The photodiode represented in FIG. 2 comprises a structure which is a functional equivalent of the structure shown in FIG. 1, adapted for light incidence in a direction perpendicular to the deposited layers. The structural elements are as described with respect to FIG. 1, one of the electrodes 5 being shown as provided with an opening for the passage of incident radiation. Alternatively, an electrically conductive, optically transparent electrode material such as, e.g. indium-tin oxide can be used, thereby obviating the need for an opening.

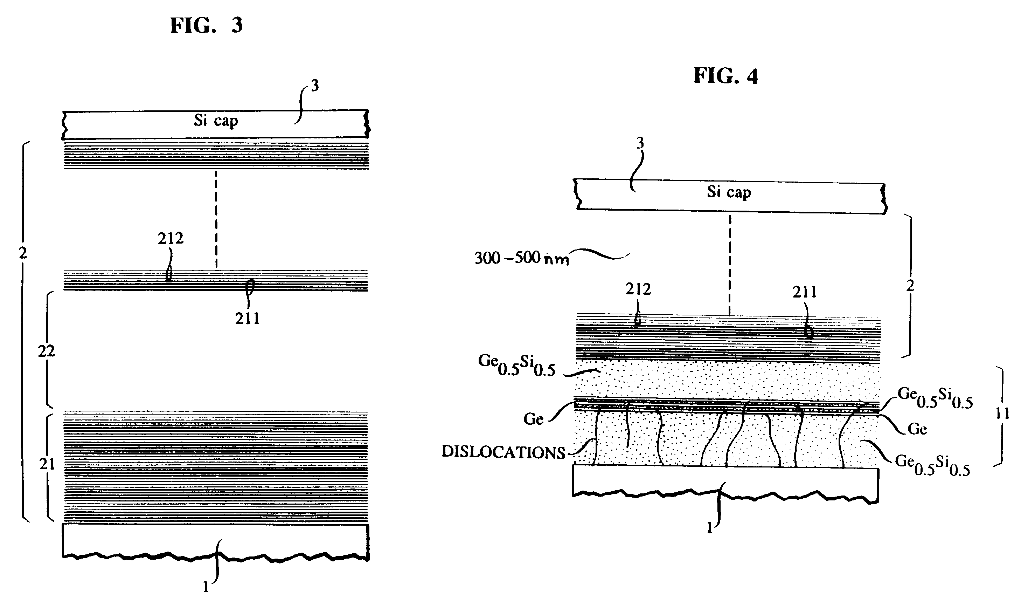

The layered structure shown in FIG. 3 represents one specific embodiment of the invention, involving the use of a silicon substrate having (100)-orientation, and including alternating layers of germanium and silicon as the Group-IV semiconductor materials. Specifically, FIG. 3 shows silicon substrate 1 which, as in FIG. 1 and 2, typically includes a buffer layer. The structure further comprises a layer 21 comprising 4 to 5 periods of alternating layers consisting of 4 atomic monolayers 211 of germanium and 4 atomic monolayers 212 of silicon. The number of periods is limited in the interest of freedom from dislocations; in the present case, a number of periods greater than 5 is likely to lead to dislocations. (While the presence of dislocations is generally undesirable, a limited number may be tolerated depending on device application. In photodetector applications, their number is preferably limited to less than 10⁵/cm².)

Further shown is an auxiliary layer 22 of silicon which is included in the interest of limiting average strain, such limitation of strain being concomitant to limitation of the average germanium concentration in the layered structure. (Strain considerations are the same as in the deposition of Si-GeₓSi₁₋ₓ alternating layers; in this respect, see, e.g., J. C. Bean et al., "GeₓSi₁₋ₓ/Si Strained-layer Superlattice Grown by Molecular Beam Epitaxy", *Journal of Vacuum Science and Technology A,* Vol. 2 (1984), pp. 436-440 or R. Hull et al., "Stability of Semiconductor Strained-layer Superlattices", *Applied Physics Letters,* Vol. 48 (1986), pp. 56 et seq.

The thickness of layer 22 may typically be in the range from 10 to 15 nanometers, preferred thickness being directly related to the number of times the layered structure described so far with respect to FIG. 3 is to be repeated. Typical over-all thickness of the resulting absorption region 2 is in an approximate range from 1 to 2 micrometers as resulting from approximately 50 to 100 repetitions.

Device manufacture typically involves the use of a number of well-established techniques such as, e.g., plasma etching, oxidation, oxide deposition, ion implantation, and metallization. Currently, molecular beam epitaxy is the method of choice for the deposition of ordered layers of Group-IV material on a silicon substrate; in this respect, see, e.g., U.S. patent 4,529,455, issued July 16, 1985 to J. C. Bean et al.

Also within the scope of the invention, the layered structure shown in FIG. 4 represents an alternative to the structure shown in FIG. 3. Here again, a (100)-oriented silicon substrate is used; however, in this configuration the layered structure is deposited on a "strain-matched" Ge_{0.5}Si_{0.5} buffer layer 11, permitting the deposition of an arbitrarily large number of periods of 4 atomic monolayers Ge and 4 atomic monolayers Si. In this case, the buffer layer includes a "dislocation trap" consisting of a superlattice of alternating sublayers of Ge_{0.5}Si_{0.5} and of Ge or, more generally, GeₓSi₁₋ₓ, x > 0.5.

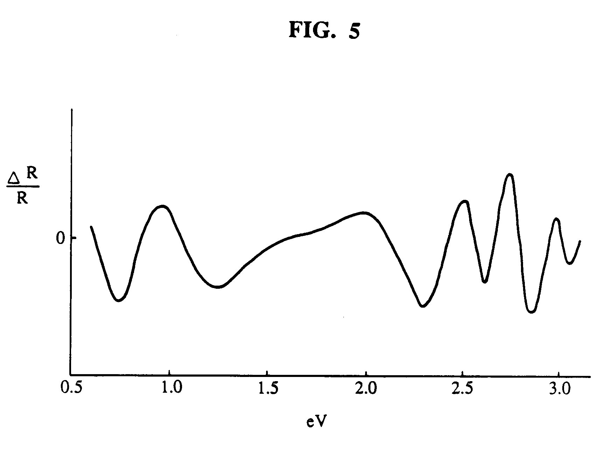

Graphically represented in FIG. 5 is a relationship between energy (expressed in units of eV) and relative modulated reflectance (a dimensionless quantity) as experimentally determined by means of electroreflectance measurements. This technique, described, e.g., by T. P. Pearsall et al., "Electroreflectance Spectroscopy of Si-GeₓSi₁₋ₓ Quantum-well Structures", *Physical Review B,* Vol. 33 (1986), pp. 6821-6830, is responsive solely to direct transitions and is not influenced by other factors affecting reflectivity such as, e.g., absorption by defects and impurities.

Measurements were carried out on a sample consisting of alternating 4 atomic monolayers Ge and 4 atomic monolayers Si on a (100)-oriented silicon substrate as schematically depicted in FIG. 3; the measurements clearly show an absorption peak near 0.76 eV. The sample was further tested by carrying out photoconductivity measurements which also showed this peak. (While not sufficient for positive identification of direct-transition peaks, photoconductivity is a necessary condition for direct transition.)

Observed peaks thus indicate energies at which a structure is suitable for light detection: Prominent in this respect are peaks near 2.8, 2.58, 2.31, 1.25, and 0.76 eV, the latter corresponding to a wavelength of approximately 1.6 micrometer. This observed distribution of peaks may be compared with the following, completely different distribution as expected for a Ge_{0.5}Si_{0.5} random alloy: 3.03, 2.80, 2.64, 2.59, and 2.41 eV, and it is apparent upon comparison that the ordered structure has device applications which are not shared by the alloy.

For the most part, the above description of a preferred embodiment of the invention has been based on a structure of alternating 4 atomic monolayers Ge and 4 atomic monolayers Si. Such structure has been described as particularly suited for photodetector use at a wavelength of approximately 1.6 micrometer and, indeed, measurements carried out on a number of Ge-Si structures including other than 4-and-4 monolayers were found not to be distinguished in this respect. However, all ordered structures show significant, distinct modification of the electronic spectrum as compared with the spectrum of silicon, germanium, or a silicon-germanium random alloy of the same average composition.

Among further variations within the scope of the invention are the use of dopants such as, e.g., boron or phosphorus (indeed, the use of suitable dopants may lead to enhanced device performance), the use of differently oriented substrates, the use of substrates other than silicon and, in particular, of suitable compound-semiconductor substrates. Of particular interest in this respect are Group-III-V materials such as, e.g., gallium arsenide.

Among other properties of interest are the mobility of electrons and/or holes, the degree of resistance to chemical attack, the ease of passivation by a native oxide, the degree of radiation hardness, the phonon spectrum and density of states, and the possibility of nonlinear optical activity as desired for optical modulation and switching applications.

## Claims

1. A photosensitive device comprising a substrate (1) and a plurality of layers deposited on a surface of said substrate and parallel to the surface of said substrate, the crystallographic structure of said surface being compatible with an ordered structure of Group-IV semiconductor material, wherein
said plurality of layers comprises alternating first and second ordered layers having a thickness which is less than or equal to 8 atomic monolayers,
said first layers (211) consisting of germanium semiconductor material in ordered form, and
said second layers (212) consisting of silicon semiconductor material in ordered form,
whereby electroabsorption properties for radiation near a wavelength of 1.6 micrometers of said plurality of layers is significantly different from the corresponding property of a reference alloy consisting of germanium and silicon in random combination and having the same average composition

2. The device of claim 1 in which said plurality of layers is repeated on an auxiliary layer (22) which comprises silicon and which does not comprise a significant amount of germanium.

3. The device of claim 1, said device being designed for optical radiation incident on said plurality of layers.

4. The device of claim 3 in which said first layers consist essentially of 4 atomic monolayers of germanium and in which said second layers consist essentially of 4 atomic monolayers of silicon,

5. The device of claim 1 in which said substrate consists essentially of silicon having essentially (100) orientation.

6. The device of claim 5 in which said plurality of layers is deposited on a buffer layer which comprises a dislocation trap region.

## Patentansprüche

1. Photoempfindliche Einrichtung mit einem Substrat (1) und einer Vielzahl von Schichten, die auf einer Oberfläche des Substrats abgeschieden und parallel zu der Oberfläche des Substrats sind, wobei die kristallographische Struktur der Oberfläche mit einer geordneten Struktur von Gruppe-IV-Halbleitermaterial kompatibel ist,
wobei
die Vielzahl von Schichten abwechselnd erste und zweite geordnete Schichten mit einer Dicke enthalten, die geringer oder gleich acht atomaren Monoschichten ist,
die ersten Schichten (211) aus einem Germanium-Halbleitermaterial in geordneter Form bestehen, und
die zweiten Schichten (212) aus Silicium-Halbleitermaterial in geordneter Form bestehen,
wobei Elektroabsorptionseigenschaften für Strahlung nahe einer Wellenlänge von 1,6 µm der Vielzahl von Schichten signifikant verschieden von den entsprechenden Eigenschaften einer Referenzlegierung sind, die aus Germanium und Silicium in willkürlicher Kombination besteht und die gleiche mittlere Zusammensetzung hat.

2. Einrichtung nach Anspruch 1,
dadurch gekennzeichnet, daß die Vielzahl von Schichten auf einer Hilfsschicht (22) wiederholt wird, die Silicium enthält und die keinen signifikanten Betrag an Germanium enthält.

3. Einrichtung nach Anspruch 1,
dadurch gekennzeichnet, daß die Einrichtung für auf die Vielzahl von Schichten einfallende optische Strahlung konstruiert ist.

4. Einrichtung nach Anspruch 3,
dadurch gekennzeichnet, daß die ersten Schichten im wesentlichen aus vier atomaren Monoschichten aus Germanium bestehen und die zweiten Schichten im wesentlichen aus vier atomaren Monoschichten aus Silicium bestehen.

5. Einrichtung nach Anspruch 1,
dadurch gekennzeichnet, daß das Substrat im wesentlichen aus Silicium mit im wesentlichen (100)-Orientierung besteht.

6. Einrichtung nach Anspruch 5,
dadurch gekennzeichnet, daß die Vielzahl von Schichten auf einer Pufferschicht abgeschieden ist, die einen Versetzungshaftstellenbereich enthält.

## Revendications

1. Un dispositif photosensible comprenant un substrat (1) et un ensemble de couches déposées sur une surface de ce substrat et parallèles à la surface du substrat, la structure cristallographique de cette surface étant compatible avec une structure ordonnée d'un matériau semiconducteur du Groupe IV, dans lequel
l'ensemble de couches comprend des premières et secondes couches ordonnées alternées ayant une épaisseur qui est inférieure ou égale à 8 couches monoatomiques,
les premières couches (211) consistant en un matériau semiconducteur sous forme ordonnée qui est du germanium, et
les secondes couches (212) consistant en un matériau semiconducteur sous forme ordonnée qui est du silicium,
grâce à quoi les propriétés d'électro-absorption pour le rayonnement au voisinage d'une longueur d'onde de 1,6 micromètre de l'ensemble de couches, sont notablement différentes des propriétés correspondantes d'un alliage de référence consistant en germanium et en silicium en combinaison aléatoire, et ayant la même composition moyenne.

2. Le dispositif de la revendication 1, dans lequel l'ensemble de couches est répété sur une couche auxiliaire (22) qui comprend du silicium et qui ne comprend pas une quantité notable de germanium.

3. Le dispositif de la revendication 1, ce dispositif étant conçu pour travailler avec un rayonnement optique qui tombe sur l'ensemble de couches.

4. Le dispositif de la revendication 3, dans lequel les premières couches consistent essentiellement en 4 couches monoatomiques de germanium, et dans lequel les secondes couches consistent essentiellement en 4 couches monoatomiques de silicium.

5. Le dispositif de la revendication 1, dans lequel le substrat consiste essentiellement en silicium ayant pratiquement une orientation (100).

6. Le dispositif de la revendication 5, dans lequel l'ensemble de couches est déposé sur une couche tampon qui constitue une région de piège de dislocations.
